# EUROPÄISCHE PATENTANMELDUNG

(11) **EP 0 911 868 A2**
(43) Veröffentlichungstag der Anmeldung: **28.04.1999**
(21) Anmeldenummer: 98119239.6
(22) Anmeldetag: 12.10.1998
(51) Int. Cl.: H01L 21/00

(54) **Einrichtung zum Greifen von Magazinen**

(30) Priorität: 24.10.1997 DE 29718994 U
(71) Anmelder: SIEMENS AKTIENGESELLSCHAFT, 80333 München (DE)
(72) Erfinder: Möges, Gerhard, Dipl.-Ing., 90537 Feucht (DE); Kratzer, Michael, Dipl.-Ing., 91187 Röttenbach (DE); Odgen, Mark, Dipl.-.Ing., 90429 Nürnberg (DE)

(57) **Zusammenfassung**

Es wird ein Robotergreifer zum Ergreifen von Magazinen (M) für Leadframes (L) benutzt, dessen Greifer als Formschlußelemente (F1,F2) an einer Magazinwand (S1) angreifen. Damit wird eine Druckbelastung der Magazine (M) ausgeschlossen. Die Formschlußelemente (F1,F2) verhindern durch ihre Gestalt ferner ein Herausrutschen der Leadframes (L) aus dem Magazin (M) bei hohen Beschleunigungen.

## Beschreibung

Die Erfindung bezieht sich auf eine Einrichtung zum Greifen von Magazinen für plattenförmiges Gut, wobei die Magazine als an zwei gegenüberliegenden seitlichen Seiten offene Kastenprofile ausgestaltet sind, und wobei die beiden anderen Seiten im Innenraum des Profils korrespondierende Führungen für das waagerecht einschiebbare Gut aufweisen.

Derartige Einrichtungen sind beispielsweise aus der EP 0 412 945 A1 bekannt. Als plattenförmiges Gut sind in der dabei sogenannte "Leadframes" vorgesehen. Das kastenförmige Profil wird dabei durch zwei mit inneren Führungsschlitzen versehene Wangen realisiert, die durch Strebenelemente miteinander verbindbar sind. Das Greifen der Magazine erfolgt mittels eines Roboters, der formschlüssig in an der Oberseite oberhalb des Schwerpunktes der Magazine angeordnete Löcher eingreift. Damit ist zwar ein sicheres Eingreifen der Magazine gewahrleistet, jedoch wird bei starken Beschleunigungsbewegungen zum einen die Aufhängung stark belastet, zum anderen wird ein starkes Drehmoment auf die Roboterhand ausgeübt.

Aus der EP 0 597 052 B1 ist ein weiterer Greifer der eingangs genannten Art bekannt, bei dem Klemmbacken die beiden offenen Ränder der dem Greifer unmittelbar benachbarten Kastenprofilwand ergreifen. Damit wird zwar sichergestellt, daß Beschleunigungskräfte am Magazin gut zum Greifmechanismus übertragen werden, jedoch ist ein kräftiger Anpressdruck der Greifer erforderlich, wodurch die Magazine sehr stark mechanisch belastet werden können.

Aufgabe der Erfindung ist es, eine Einrichtung der eingangs genannten Art so auszubilden, daß die Magazine auch bei hohen Beschleunigungen sicher und drehmomentenarm gehalten werden können, wobei jedoch für dieses Halten kein Anpressdruck auf die Magazine ausgeübt wird.

Gemäß der Erfindung wird diese Aufgabe dadurch gelöst, daß als Greifer zwei im Bereich jeder der Öffnungen jeweils an den Rand des Kastenprofils angepaßte Formschlußelemente vorgesehen sind.

Eine erste vorteilhafte Ausbildung der Erfindung ist dadurch gekennzeichnet, daß durch die Formschlußelemente nur die beiden offenen Ränder der dem Greifer unmittelbar benachbarten Kastenprofilwand ergreifbar sind. Dadurch reichen zwei relativ schmale Formschlußelemente zum sicheren Ergreifen des jeweiligen Magazins aus.

Dadurch, daß die Ränder nutenartige Vertiefungen zum Eingriff für bolzenartige Ausgestaltungen der Formschlußelemente aufweisen, können die Formschlußelemente als an ihren oberen und unteren Enden offene U-Profile ausgestaltet sein, denn der Formschluß für die vertikale Richtung wird durch die Nut-Bolzen-Eingriffe erreicht.

Eine weitere vorteilhafte Ausbildung der Erfindung ist dadurch gekennzeichnet, daß durch die Formschlußelemente die Führungen übergreifbar sind. Dadurch wird verhindert, daß bei starken Beschleunigungskräften das horizontal in den Magazinen angebrachte Gut ungewollt aus seiner Lage geschleudert wird.

Dadurch, daß Mittel zum Synchronisieren der Greifbewegung vorgesehen sind, ist nach dem Vorpositionieren des gesamten Greifmechanismus gegenüber dem jeweiligen Magazin durch das synchronisierte Greifen ein stoßfreies Aufnehmen der Magazine gewährleistet.

Ein Ausführungsbeispiel der Erfindung ist in der Zeichnungdargestellt und wird im folgenden näher erläutert:

Die Darstellung zeigt perspektivisch in Form eines offenen Kastenprofils ein Magazin M. Dieses möge aus Seitenteilen S1 und S2 bestehen, die über beliebige Elemente, seien es plattenförmige Elemente oder stegförmige Elemente, miteinander verbunden sind. Wesentlich ist, daß die Seitenteile S1 und S2 an ihren einander zugewandten Seiten korrespondierende Führungen aufweisen, in die plattenförmiges Gut, beispielsweise ein Leadframe L eingeschoben werden kann.

Wenn ein bestücktes oder auch ein unbestücktes Magazin M transportiert werden soll, kann dies mit Hilfe eines, der Übersichtlichkeit halber nicht gezeigten, Roboters erfolgen, an dessen Roboterspitze ein Greifer vorgesehen ist, der eben das Magazin M oder jeweils eines der weiteren Magazine greifen und transportieren kann. Wesentlich für diesen Greifvorgang sind nun gemäß der Erfindung zwei Formschlußelemente F1 und F2, die, wie durch ein Doppelpfeil angedeutet, gegeneinander beweglich sind. Das Auslösen dieser Bewegung kann durch einen Mechanismus erfolgen, der aus zwei Zahnstangen Z1 und Z2 besteht, von denen die Zahnstange Z2 durch einen positionierenden Antrieb bewegt wird. Durch ein Zahnrad ZR zwischen den Zahnstangen Z1 und Z2 ist dabei sichergestellt, daß beide Formschlußelemente F1 und F2 gleicherweise gegensinnig zueinander bewegbar sind. Mittels dieser Greifbewegung können die Formschlußelemente F1 und F2 die Seitenwand S1 des Magazins M im Bereich der Magazinöffnung umgreifen und in einen Formschluß gebracht werden, wobei ein Kippen des Magazins M durch die U-Form der Formschlußelemente F1 und F2 verhindert wird und wobei ein nach unten oder nach oben Rutschen des Magazins M innerhalb der u-förmigen Führungen der Formschlußelemente F1 und F2 dadurch verhindert wird, daß in diesen zwei Bolzen B1 und B2 angeordnet sind, die in korrespondierende nutartige Kerben K2 und K4 des Magazins M eingreifen. Am Magazin M sind sechs weitere Kerben vorgesehen, damit das Magazin auch in einer Überkopflage bzw. in einer Lage, bei der die Seite S1 zu einem Greifmechanismus hinweist, gehalten werden können. Von den dazu erforderlichen symmetrisch angeordneten Kerben sind in der Darstellung außer den zuvor beschriebenen Kerben K2 und K4, die Kerben K1 und K2 sowie K5 und K6 ersichtlich.

Durch gestrichelte Pfeile ist angedeutet, daß der synchronisierende Greifmechanismus auf die Formschlußelemente F1 und F2 in Höhe von deren Zentrum angreift, wodurch unnötige Hebelkräfte an den Formschlußelementen F1 und F2 vermieden werden.

Der Antrieb A kann beliebig hydraulisch, elektrisch oder pneumatisch betrieben werden, jedoch ist es wesentlich, daß er als positionierender Antrieb ausgebildet ist, damit keine Kräfte von den Führungselementen F1 und F2 auf das jeweils zu haltende Magazin, so ds Magazin M, ausgeübt werden. Dazu bietet es sich an, sicherheitshalber einen vorgegebenen Toleranzabstand zwischen den Folgeschlußelementen F1 bzw. F2 zum Magazin M vorzugeben.

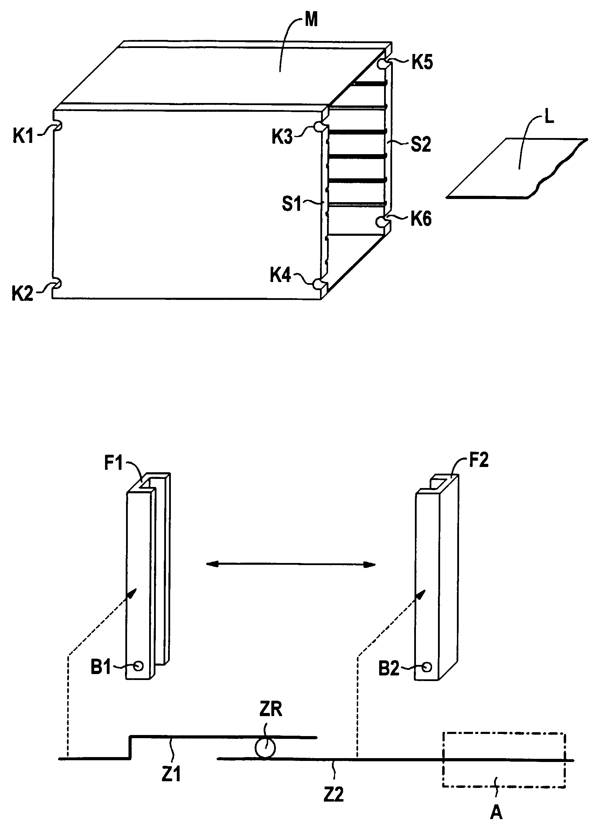

## Patentansprüche

1. Einrichtung zum Greifen von Magazinen für plattenförmiges Gut, wobei die Magazine als an zwei gegenüberliegenden seitlichen Seiten offene Kastenprofile ausgestaltet sind und wobei die beiden anderen Seiten im Innenraum des Profils korrespondierende Führungen für das waagerecht einschiebbare Gut aufweisen, dadurch gekennzeichnet, daß als Greifer zwei im Bereich jeder der Öffnungen jeweils an den Rand des Kastenprofils (M) angepaßte Formschlußelemente (F1, F2) vorgesehen sind.

2. Einrichtung nach Anspruch 1, **dadurch gekennzeichnet,** daß durch die Formschlußelemente (F1, F2) nur die beiden offenen Ränder der dem Greifer unmittelbar benachbarten Kastenprofilwand (S1) ergreifbar sind.

3. Einrichtung nach einem der vorstehenden Ansprüche, **dadurch gekennzeichnet,** daß die Ränder nutenartige Vertiefungen (K1 bis K6) zum Eingriff für bolzenartige Ausgestaltungen (B1, B2)der Formschlußelemente (F1, F2) aufweisen.

4. Einrichtung nach einem der vorstehenden Ansprüche, **dadurch gekennzeichnet,** daß durch die Formschlußelemente (F1, F2) die Führungen übergreifbar sind.

5. Einrichtung nach einem der vorstehenden Anprüche, **dadurch gekennzeichnet,** daß Mittel (Z1, Z2, ZR) zum Synchronisieren der Greifbewegung vorgesehen sind.
